# EUROPEAN PATENT APPLICATION

(11) **EP 4 656 766 A1**
(43) Date of publication of application: **03.12.2025**
(21) Application number: 25172435.7
(22) Date of filing: 24.04.2025
(51) Int. Cl.: C23C 14/04, C23C 14/12

(54) **MASK STAGE AND DEPOSITION APPARATUS INCLUDING THE SAME**

(30) Priority: 21.05.2024 KR 20240065964
(71) Applicant: Samsung Display Co., Ltd., Yongin-si, Gyeonggi-do 17113 (KR)
(72) Inventor: BAEK, Dae Won, Yongin-si (KR); KIM, Eui Gyu, Yongin-si (KR); CHO, Young Sun, Yongin-si (KR)
(74) Representative: Marks & Clerk LLP

(57) **Abstract**

A mask stage includes a stage frame supporting a mask frame, a plurality of moving modules disposed on the stage frame to overlap the mask frame, and a plurality of attachment modules disposed on the stage frame to overlap the mask frame, wherein the plurality of moving modules and the plurality of attachment modules are spaced apart from each other, wherein at least one attachment module is disposed between the plurality of moving modules.

## Description

### BACKGROUND

### 1. Field

The invention relates to a mask stage and a deposition apparatus including the same.

### 2. Description of the Related Art

An organic light emitting display device is a display device using a phenomenon in which electrons injected from a cathode and holes injected from an anode are recombined to form excitons in an organic thin film, and light of a specific wavelength is generated by energy from the formed excitons.

In the organic light emitting display device, a vacuum deposition method may be used as a method of depositing an organic material or metal which is used as an electrode on a substrate. The vacuum deposition method is a method of arranging a substrate, which will grow an organic thin film, inside a vacuum chamber, tightly adhering a mask assembly having the same pattern as that of a thin film which is to be formed, to the substrate, evaporating or sublimating a deposition material such as an organic material by using a deposition source and then depositing the deposition material on the substrate.

The mask assembly used in the vacuum deposition method may be tightly adhered to the substrate by being supported by the mask stage.

### SUMMARY

An embodiment of the invention provides a mask stage and a deposition apparatus including the same, in which a tight adhesion between a mask assembly and the mask stage may be increased, and a pattern opening of the mask assembly may be aligned on a deposition area of a substrate.

Embodiments of the invention are not limited to those set forth herein. The above and other embodiments of the invention will become more apparent to one of ordinary skill in the art to which the invention pertains by referencing the detailed description given below.

According to an embodiment, a mask stage includes a stage frame supporting a mask frame, a plurality of moving modules disposed on the stage frame to overlap the mask frame, and a plurality of attachment modules disposed on the stage frame to overlap the mask frame, wherein the plurality of moving modules and the plurality of attachment modules are spaced apart from each other, wherein at least one attachment module is disposed between the plurality of moving modules.

In an embodiment, the plurality of moving modules are disposed to be spaced apart from each other in one direction, wherein the plurality of attachment modules are disposed to be spaced apart from each other in the one direction to be disposed between the plurality of moving modules.

In an embodiment, some of the plurality of attachment modules are disposed to be spaced apart from each other in the other direction crossing the one direction.

In an embodiment, the plurality of moving modules include a first moving module and a second moving module, and the plurality of attachment modules are disposed within a range from a position far away from the first moving module to be as much as a length of about 20% relative to a length between the first moving module and the second moving module to a position far away from the first moving module to be as much as a length of about 80% relative thereto.

In an embodiment, one of the plurality of attachment modules is disposed at a position far away from the first moving module to be as much as a length of about 50% relative to a length between the first moving module and the second moving module.

In an embodiment, the stage frame includes a first plate, a second plate, a third plate and a fourth plate, wherein the first plate and the third plate are extended in a second direction, and are disposed in parallel with each other, and the second plate and the fourth plate are extended in a first direction crossing the second direction, and are disposed in parallel with each other.

In an embodiment, the plurality of moving modules are disposed on the first plate and the third plate along the second direction, and the plurality of attachment modules are respectively disposed between the plurality of moving modules disposed on the first plate and the third plate.

In an embodiment, the plurality of moving modules are disposed on one side and the other side of the first plate and the third plate in the second direction, respectively.

In an embodiment, the plurality of attachment modules are disposed on the first plate and the third plate along the second direction.

In an embodiment, the plurality of moving modules are disposed on the second plate and the fourth plate along the first direction, the plurality of attachment modules are disposed on the second plate and the fourth plate along the first direction, and the plurality of moving modules and the plurality of attachment modules are alternately disposed.

In an embodiment, the plurality of moving modules are disposed to be spaced apart from one side and the other side of the second plate and the fourth plate in the first direction.

In an embodiment, a portion of the plurality of attachment modules is disposed between one side of the second plate and the fourth plate in the first direction, and the moving module is spaced apart from one side of the second plate and the fourth plate in the first direction, and is disposed between the other side of the second plate and the fourth plate in the first direction and the moving module is spaced apart from the other side of the second plate and the fourth plate in the first direction.

In an embodiment, the moving module moves the mask frame in an up and down direction relative to the stage frame, and the attachment module attaches the mask frame to the stage frame.

In an embodiment, the moving module includes a main body embedded in the stage frame, and a moving member ejected toward an upper portion of the stage frame from the main body.

In an embodiment, the attachment module is embedded in the stage frame, and is partially exposed to the upper portion of the stage frame.

In an embodiment, the attachment module is provided as a zero-electromagnet in which a magnetic force is removed when a power source is applied and the magnetic force is generated when the power source is removed.

According to an embodiment, a deposition apparatus includes a chamber, a substrate holder disposed inside the chamber supporting a substrate, a mask assembly disposed below the substrate, a mask stage supporting the mask assembly, and a deposition source emitting a deposition material to the mask assembly, wherein the mask stage includes, a plurality of moving modules that overlap the mask assembly, and a plurality of attachment modules that overlap the mask assembly, where at least one attachment module is disposed between the plurality of moving modules.

In an embodiment, the plurality of moving modules are disposed to be spaced apart from each other in one direction, and the plurality of attachment modules are disposed to be spaced apart from each other in the one direction and to be disposed between the plurality of moving modules.

In an embodiment, some of the plurality of attachment modules are disposed to be spaced apart from each other in the other direction crossing the one direction.

In an embodiment, the plurality of moving modules include a first moving module and a second moving module, the plurality of attachment modules are disposed within a range from a position far away from the first moving module to be as much as a length of about 20% relative to a length between the first moving module and the second moving module to a position far away from the first moving module to be as much as a length of about 80% relative thereto.

In an embodiment, one of the plurality of attachment modules is disposed at a position far away from the first moving module to be as much as a length of about 50% relative to the length between the first moving module and the second moving module.

At least some of the above and other features of the invention are set out in the claims.

In an embodiment, in the mask stage and the deposition apparatus, a tight adhesion between a mask assembly and the mask stage may be increased, and a pattern opening of the mask assembly may be aligned on a deposition area of a substrate.

The effects, according to the embodiments, are not limited to those mentioned above and more various effects are included in the following description of the invention.

### BRIEF DESCRIPTION OF THE DRAWINGS

The above and other aspects and features of the invention will become more apparent by describing in detail example embodiments thereof with reference to the accompanying drawings, in which:
FIG. 1 is a schematic block diagram illustrating a deposition apparatus, according to an embodiment;
FIG. 2 is a perspective view of a mask assembly of FIG. 1, according to an embodiment;
FIG. 3 is a perspective view of a divided mask of FIG. 2, according to an embodiment;
FIG. 4 is a perspective view illustrating a mask assembly and a mask stage of FIG. 1, according to an embodiment;
FIG. 5 is a perspective view of a stage frame of a mask stage of FIG. 1, according to an embodiment;
FIG. 6 is a plan view of a mask stage of FIG. 1, according to an embodiment;
FIG. 7 is a cross-sectional view taken along line AA' of FIG. 6, according to an embodiment;
FIG. 8 is a cross-sectional view taken along line BB' of FIG. 6, according to an embodiment;
FIG. 9 is a view illustrating an example in which an attachment module is disposed between moving modules in FIG. 6, according to an embodiment;
FIG. 10 is a view illustrating another example in which an attachment module is disposed between moving modules in FIG. 6, according to an embodiment;
FIG. 11 is a view illustrating a state that a moving module of a mask stage moves a mask frame in an upward direction of the mask stage, according to an embodiment;
FIG. 12 is a view illustrating a state that an attachment module of a mask stage attaches a mask frame to a stage frame, according to an embodiment;
FIG. 13 is a view illustrating simultaneously states of FIGS. 11 and 12, according to an embodiment;
FIG. 14 is a partially enlarged view illustrating a state that a mask assembly of a deposition apparatus is tightly adhered to a substrate, according to an embodiment; and
FIG. 15 is a cross-sectional view schematically illustrating a display device manufactured using a deposition apparatus, according to an embodiment.

### DETAILED DESCRIPTION

Advantages and features of the invention and methods to achieve them will become apparent from the descriptions of example embodiments hereinbelow with reference to the accompanying drawings. However, the invention is not limited to the example embodiments disclosed herein, but may be implemented in various different ways. The example embodiments are provided for making the disclosure of the invention thorough and for fully conveying the scope of the invention to those skilled in the art.

As used herein, a phrase "an element A on an element B" refers to that the element A may be disposed directly on the element B and/or the element A may be disposed indirectly on the element B via another element C. Like reference numerals denote like elements throughout the descriptions. The figures, dimensions, ratios, angles, numbers of elements given in the drawings are merely illustrative and are not limiting.

Although terms such as first, second, etc. are used to distinguish arbitrarily between the elements such terms describe, these terms are not necessarily intended to indicate temporal or other prioritization of such elements. These terms are used to merely distinguish one element from another. Accordingly, as used herein, a first element may be a second element within the technical scope of the invention.

Features of various example embodiments of the invention may be combined partially or totally. As will be clearly appreciated by those skilled in the art, technically various interactions and operations are possible. Various example embodiments can be practiced individually or in combination.

Hereinafter, example embodiments of the invention will be described in detail with reference to the accompanying drawings.

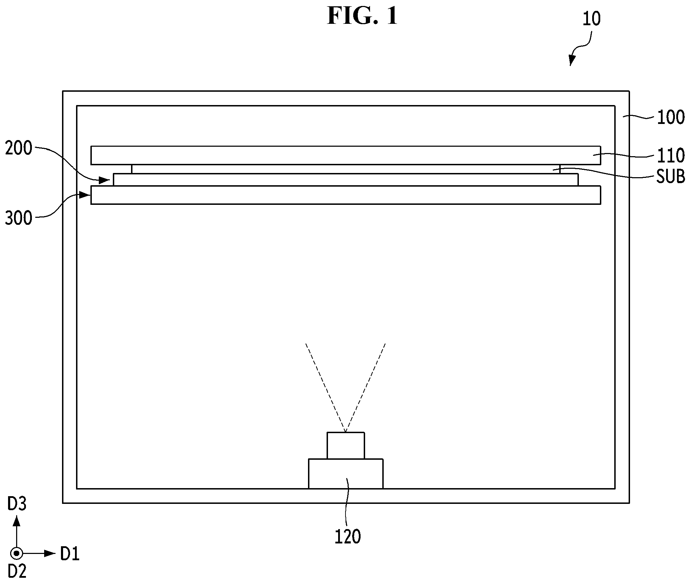

FIG. 1 is a view schematically illustrating a deposition apparatus 10, according to an embodiment.

In an embodiment and referring to FIG. 1, the deposition apparatus 10 may deposit an organic material or a metal to be used as an electrode on a substrate SUB. The deposition apparatus 10 may include a chamber 100, a substrate holder 110, a deposition source 120, a mask assembly 200 and a mask stage 300.

In an embodiment, the chamber 100 may provide a space for performing a deposition process. The inside of the chamber 100 may be maintained in a vacuum while a deposition process is being performed. Maintaining the inside of the chamber 100 in a vacuum state may mean that a pressure inside the chamber 100 is maintained in a low pressure state. The chamber 100 may include a carrying-in and out port (not shown) for carrying the substrate SUB in and out. Furthermore, the chamber 100 may include a vacuum pump (not shown) for controlling a pressure inside the chamber 100 and exhausting a deposition material that is not deposited onto the substrate SUB, and an exhaust port (not shown) connected to the vacuum pump.

In an embodiment, the substrate SUB on which an organic material or metal to be used as an electrode is deposited may be provided as an insulating substrate, a semiconductor substrate, a display device substrate or the like, but is not limited thereto. In an embodiment, the substrate SUB used in the organic light emitting display device will be described as an example. A predetermined structure may be formed on the substrate SUB through a deposition process, where the structure formed on the substrate SUB through the deposition process may be variously formed in accordance with a manufacturing process of the organic light emitting display device. For example, in a process of forming a hole injection layer, a pixel defining layer and an anode electrode may be formed on the substrate SUB. Also, in a process of forming an organic light emitting layer, not only a pixel defining layer and an anode electrode, but also a hole injection layer and a hole transporting layer may be formed on the substrate SUB.

In an embodiment, the substrate holder 110 may support the substrate SUB and may be disposed inside the chamber 100. In an embodiment, the substrate holder 110 may be disposed on an upper side inside the chamber 100, and the substrate SUB may be seated on a lower portion of the substrate holder 110 and supported by the substrate holder 110. Also, the substrate holder 110 may include a fixing member (not shown), where the fixing member may assist fixing of the substrate SUB and the mask assembly 200, and may serve to uniformly maintain a distance between the substrate SUB and the mask assembly 200. The fixing member may be provided as a detachable frame structure.

In an embodiment, the deposition source 120 may provide a deposition material to be deposited on the substrate SUB, where the deposition source 120 may be disposed inside the chamber 100, and may be disposed to face the substrate SUB. In an example embodiment, when the substrate holder 110 on which the substrate SUB is seated is disposed on an upper side inside the chamber 100, the deposition source 120 may be disposed on a lower side inside the chamber 100. The deposition source 120 may discharge the deposition material to the mask assembly 200.

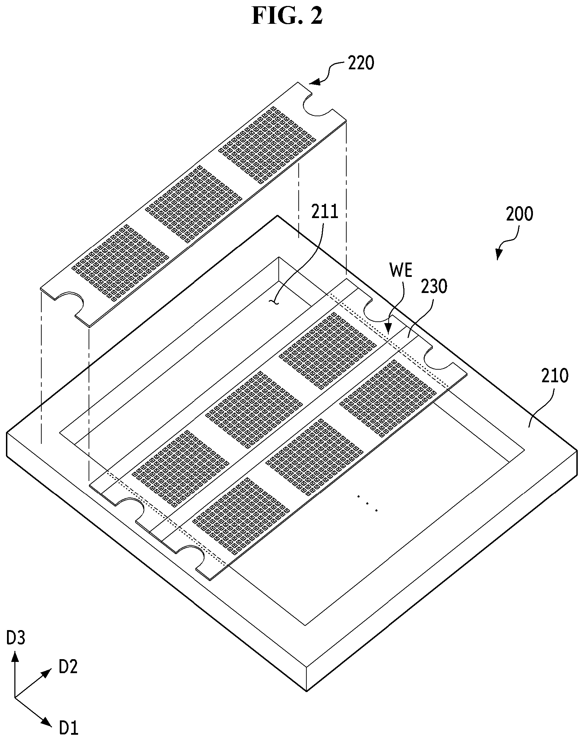

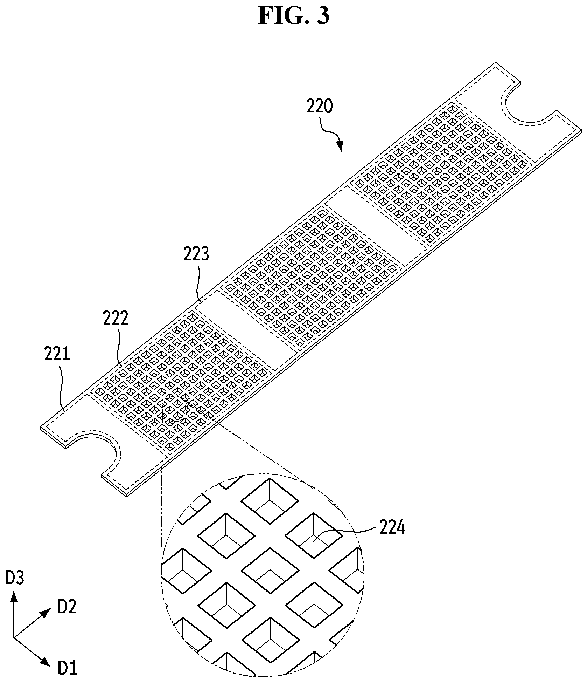

FIG. 2 is a perspective view of a mask assembly 200 of FIG. 1, according to an embodiment. FIG. 3 is a perspective view of a divided mask 220 of FIG. 2, according to an embodiment.

In an embodiment and referring to FIGS. 2 and 3, the mask assembly 200 may include a mask frame 210 and a plurality of divided masks 220 disposed on the mask frame 210.

In an embodiment, the mask frame 210 forms an outer frame of the mask assembly 200, and may have a quadrangular band shape in which a mask opening 211 is formed at the center. The mask frame 210 may have a predetermined thickness in a third direction D3 to stably support the divided mask 220 or the like. The mask frame 210 may include a pair of long sides and a pair of short sides, thereby disposing the mask opening 211 at the center. For example, the pair of long sides may be extended in a first direction D1 and may be disposed in parallel with each other in a second direction D2, and the pair of short sides may be extended in the second direction D2 and disposed in parallel with each other in the first direction D1.

In an embodiment, a planar shape of the mask opening 211 may be approximately rectangular and may provide a path through which the deposition material passes. In another embodiment, the mask frame 210 may have a rectangular band shape having the same length in both pairs of sides, and a planar shape of the mask opening 211 may be a square. The mask frame 210 may include a material having high rigidity, for example, metal such as stainless steel.

In an embodiment, the divided mask 220 may be disposed on the mask frame 210, where the divided mask 220 may have one surface (an upper surface of FIG. 3) and the other surface (a lower surface of FIG. 3). One surface of the divided mask 220 may be a surface that is in contact with the substrate SUB during a deposition process, and the other surface of the divided mask 220 may be a surface opposite to the one surface of the divided mask 220 and on which a deposition material is provided. The other surface of the divided mask 220 may be in contact with the mask frame 210.

In an embodiment, the divided mask 220 may have a shape in which a length (e.g., a length in the second direction D2) is greater than a width (e.g., a width in the first direction D1). In an embodiment, the divided mask 220 may be extended in the second direction D2, and may be divided into a plurality of portions and disposed in the second direction D2. In another embodiment, the divided mask 220 may be a mother mask integrally formed with a planar area covering the mask opening 211. In one embodiment, the divided mask 220 may be a fine metal mask made of a metal material, where the divided mask 220 may be made of metal, such as stainless steel, nickel, cobalt or their alloy. In other embodiments, the divided mask 220 may be magnetic.

In an embodiment, the divided mask 220 may include a fixing portion 221 positioned at both ends in the second direction D2, a plurality of pattern portions 222 positioned toward the center as compared with the fixing portion 221, and a rib portion 223 positioned between the pattern portions 222.

In an embodiment, the fixing portion 221 may be a portion that is in contact with and coupled to the mask frame 210. For example, the fixing portion 221 may be welded and coupled to the mask frame 210. A method of welding the fixing portion 221 to the mask frame 210 is not particularly limited, but laser welding, resistance heating welding and the like may be exemplified. The fixing portion 221 may include a welding portion WE formed by welding to the mask frame 210. The welding portion WE may be formed as a plurality of spots in an area corresponding to the fixing portion 221. The welding portion WE is illustrated as being disposed in one row in the present embodiment, but is not limited thereto. In another embodiment, the welding portion WE may be disposed in a plurality of rows or more.

In an embodiment, the pattern portion 222 is a portion in which a plurality of pattern openings 224 providing a path through which the deposition material passes are formed. A plurality of pattern portions 222 may be disposed to be spaced apart from each other in the second direction D2 of the divided mask 220. In an embodiment, although three pattern portions 222 are illustrated to be spaced apart from one another in the second direction D2, the invention is not limited thereto. Also, the rib portion 223 may be disposed between the pattern portions 222 that are disposed adjacent to each other in the second direction D2. The rib portion 223 may serve as a reference for partitioning the pattern portions 222 that are disposed adjacent to each other in the second direction D2. Since the pattern opening 224 is not formed in the rib portion 223, passing of the deposition material may be shielded.

In an embodiment, the pattern portion 222 may correspond to one display device (e.g., an organic light emitting display device). In this case, patterns corresponding to a plurality of display devices may be simultaneously deposited through a single process using one mask assembly 200. In other words, the mask assembly 200 may correspond to one mother substrate, and may simultaneously form the patterns corresponding to the plurality of display devices on the mother substrate.

In an embodiment, the pattern opening 224 may be an opening passing through the one surface and the other surface of the divided mask 220. The pattern opening 224 of the divided mask 220 aligned on the substrate SUB may expose a deposition area DA of the substrate SUB. In other words, the pattern opening 224 may have substantially the same planar shape as that of the deposition pattern desired to be formed. In an embodiment, although the pattern openings 224 are illustrated as being spaced apart from each other in the first direction D1 and the second direction D2 and arranged in a substantially matrix shape with a dot shape on a plane, the invention is not limited thereto. The pattern opening 224 may have a slit shape extending in the first direction D1 or the second direction D2 on the plane.

In an embodiment, the divided mask 220 may be fixed to the mask frame 210 by welding in a state that both ends in the second direction D2 are applied with a tensile force in the first direction D1 or the second direction D2. In another embodiment, the divided mask 220 may be tensioned not only in the first direction D1, but also in the second direction D2.

In an embodiment, a gap mask 230 may be disposed between the plurality of divided masks 220, where the gap mask 230 may be disposed at a gap between the divided masks 220 to serve to block any passing of the deposition material between the divided masks 220. The gap mask 230 may have the same length (a length in the second direction) as that of the divided mask 220. The gap mask 230 may not be provided with an opening, thereby blocking the passing of the deposition material. In an embodiment, although the gap mask 230 is illustrated as being disposed, but is not limited thereto. In another embodiment, the gap mask 230 may be omitted.

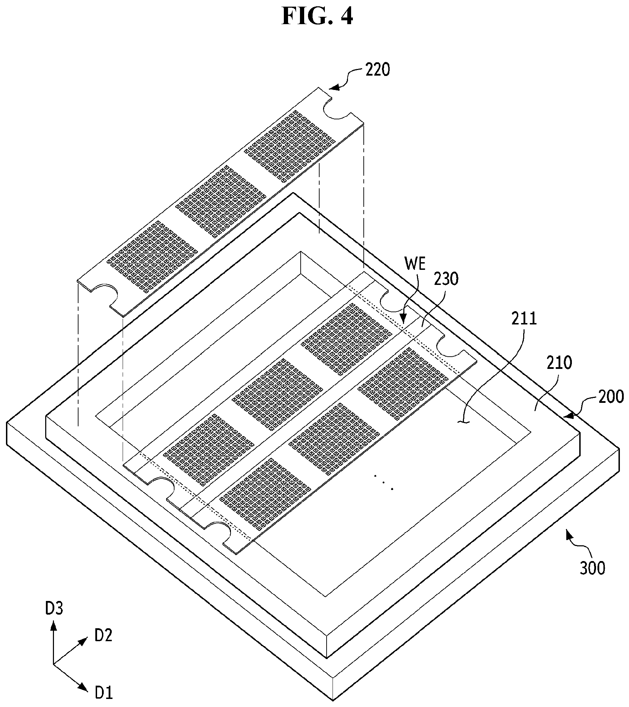

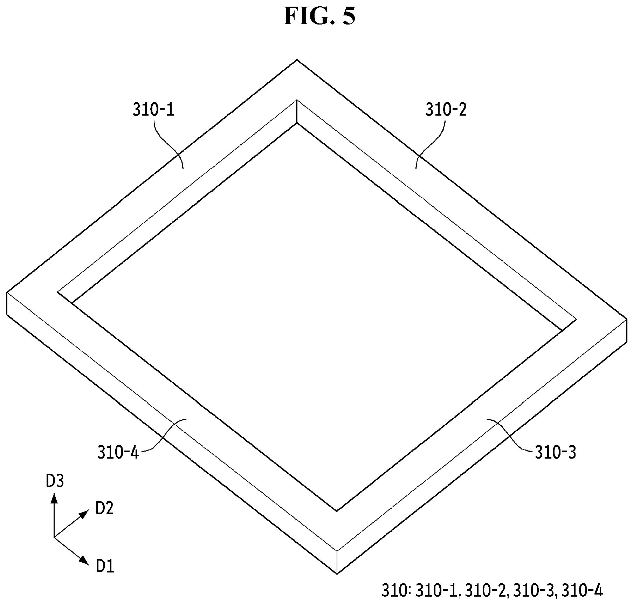

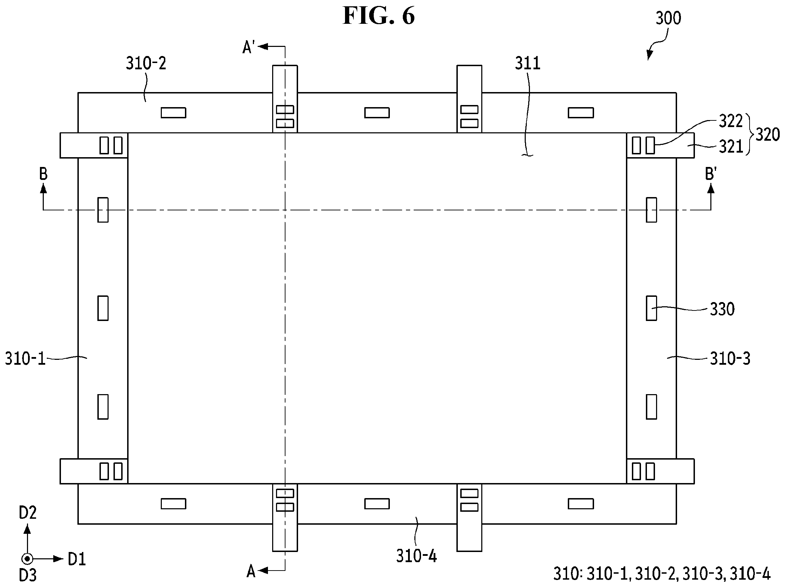

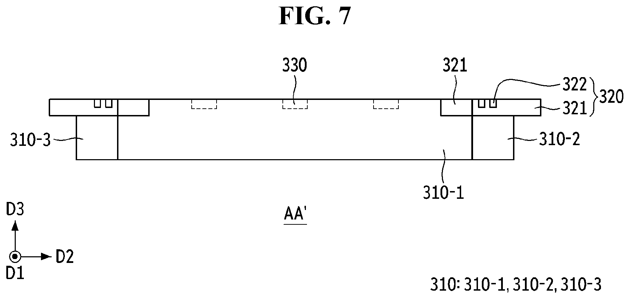

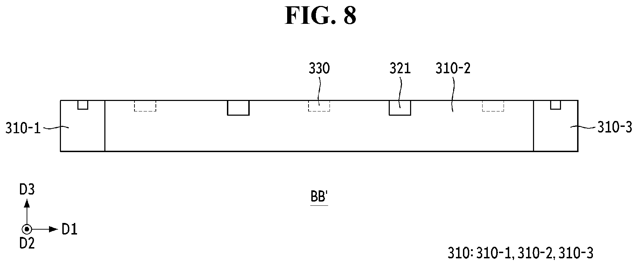

FIG. 4 is a perspective illustrating a mask assembly 200 and a mask stage 300 of FIG. 1, according to an embodiment. FIG. 5 is a perspective view of a stage frame 310 of a mask stage 300 of FIG. 1, according to an embodiment. FIG. 6 is a plan view of a mask stage 300 of FIG. 1, according to an embodiment. FIG. 7 is a cross-sectional view taken along line AA' of FIG. 6, according to an embodiment. FIG. 8 is a cross-sectional view taken along line BB' of FIG. 6, according to an embodiment.

In an embodiment and referring to FIGS. 4 to 8, the mask stage 300 may be disposed below the mask assembly 200 to support the mask assembly 200,where the mask stage 300 may include a stage frame 310, a moving module 320 and an attachment module 330.

In an embodiment, the stage frame 310 may be disposed below the mask assembly 200 to overlap the mask frame 210 of the mask assembly 200, thereby supporting the mask frame 210. The stage frame 310 forms an outer frame of the mask stage 300, and may have a rectangular band shape having a stage opening 311 formed at the center thereof. The stage frame 310 may have a predetermined thickness in the third direction D3 to stably support the mask frame 210 and the like. The stage frame 310 may include a first plate 310-1, a second plate 310-2, a third plate 310-3 and a fourth plate 310-4.

In an embodiment, the first plate 310-1 and the third plate 310-3 may be provided as plates having a predetermined thickness extending in the second direction D2. The first plate 310-1 and the third plate 310-3 may be formed to have a thickness in the third direction D3. The first plate 310-1 and the third plate 310-3 may be spaced apart from each other in the first direction D1 that is directed to be orthogonal on a plane in the second direction D2 and are disposed in parallel with each other.

In an embodiment, the second plate 310-2 and the fourth plate 310-4 may be provided as plates having a predetermined thickness extending in the first direction D1, where the second plate 310-2 and the fourth plate 310-4 may be formed to have a thickness in the third direction D3. The second plate 310-2 and the fourth plate 310-4 may be spaced apart from each other in the second direction D2 and disposed to be in parallel with each other.

In an embodiment, the first plate 310-1, the second plate 310-2, the third plate 310-3 and the fourth plate 310-4 may be connected to one another to define the stage opening 311 at the center thereof. For example, one side of the second plate 310-2 in the first direction D1 may be connected to one side of the first plate 310-1 in the second direction D2, and one side of the fourth plate 310-4 in the first direction D1 may be connected to the other side of the first plate 310-1 in the second direction D2. Also, the other side of the second plate 310-2 in the first direction D1 may be connected to one side of the third plate 310-3 in the second direction D2, and the other side of the fourth plate 310-4 in the first direction D1 may be connected to the other side of the third plate 310-3 in the second direction D2. In this way, the first plate 310-1, the second plate 310-2, the third plate 310-3 and the fourth plate 310-4 may be connected to one another, whereby the stage opening 311 may be formed at the center of the stage frame 310. The stage opening 311 may overlap the mask opening 211 of the mask assembly 200. One side in the first direction D1 may be a left side of FIG. 6, the other side in the first direction D1 may be a right side of FIG. 6, one side in the second direction D2 may be an upper side of FIG. 6, and the other side in the second direction D2 may be a lower side of FIG. 6.

In an embodiment, the moving module 320 may be disposed on the stage frame 310 to overlap the mask frame 210. A plurality of moving modules 320 may be provided and disposed to be spaced apart from each other on the stage frame 310, where the moving module 320 may move the mask frame 210 in an up and down direction of the stage frame 310.

In an embodiment, the moving module 320 may include a main body 321 and a moving member 322.

The main body 321 may be provided as a plate of a substantially rectangular shape having a predetermined thickness, where the thickness of the main body 321 may be thinner than that of the stage frame 310. The main body 321 may be disposed to be embedded in the stage frame 310, and an upper portion thereof may be disposed to be exposed to an upper portion of the stage frame 310.

The moving member 322 may be disposed inside the main body 321 and may be disposed to be ejected toward the upper portion of the main body 321. In other words, the moving member 322 may be disposed inside the main body 321 to be ejected toward the upper portion of the stage frame 310. A plurality of moving members 322 may be provided to be spaced apart from each other. The moving member 322 may be in contact with a lower surface of the mask frame 210 when the mask frame 210 is supported by the stage frame 310.

In an embodiment, the attachment module 330 may be disposed on the stage frame 310 to overlap the mask frame 210. A plurality of attachment modules 330 may be provided and disposed to be spaced apart from each other on the stage frame 310. The attachment module 330 may attach the mask frame 210 to the stage frame 310.

The attachment module 330 may be disposed to be embedded in the stage frame 310, and may be disposed such that an upper portion thereof is exposed to the upper portion of the stage frame 310. The attachment module 330 may be in contact with the lower surface of the mask frame 210 when the mask frame 210 is supported by the stage frame 310. The attachment module 330 may be provided as a zero-electronic magnet in which a magnetic force is removed when a power source is applied and the magnetic force is generated when the power source is removed. For example, when the power source is applied to the attachment module 330, the mask frame 210 may be separated from the attachment module 330, and when the power source is released from the attachment module 330, the mask frame 210 may be attached to the attachment module 330.

Hereinafter, the case that the moving module 320 and the attachment module 330 are disposed on the first plate 310-1, the second plate 310-2, the third plate 310-3 and the fourth plate 310-4 will be described according to an embodiment.

A plurality of moving modules 320 and a plurality of attachment modules 330 may be disposed in the first plate 310-1. The plurality of moving modules 320 and the plurality of attachment modules 330 may be disposed on the first plate 310-1 along the second direction D2.

One of the plurality of moving modules 320 may be disposed on the one side of the first plate 310-1 in the second direction D2, and the other moving module 320 may be disposed on the other side of the first plate 310-1 in the second direction D2.

The plurality of attachment modules 330 may be disposed between the moving modules 320 disposed on the first plate 310-1. In other words, the plurality of attachment modules 330 may be disposed between the moving modules 320 disposed on the one side of the first plate 310-1 in the second direction D2 and the moving modules 320 disposed on the other side of the first plate 310-1 in the second direction D2. The plurality of attachment modules 330 may be disposed on the first plate 310-1 along the second direction D2.

When the moving module 320 disposed on the one side of the first plate 310-1 in the second direction D2 is referred to as the first moving module 320 and the moving module 320 disposed on the other side of the first plate 310-1 in the second direction D2 is referred to as the second moving module 320, the plurality of attachment modules 330 may be disposed along the second direction D2 between the first moving module 320 and the second moving module 320.

The plurality of attachment modules 330 may be disposed on the first plate 310-1 within the range from a position that is located far away from the first moving module 320 by as much as a length of about 20% relative to a length between the first moving module 320 and the second moving module 320, to a position that is located far away from the first moving module 320 by as much as a length of about 80% relative to the length between the first moving module 320 and the second moving module 320.

In addition, one of the plurality of attachment modules 330 may be disposed on the first plate 310-1 at a position that is located far away from the first moving module 320 by as much as a length of about 50% relative to the length between the first moving module 320 and the second moving module 320. In other words, one of the plurality of attachment modules 330 may be disposed on the first plate 310-1 at a middle point located between the first moving module 320 and the second moving module 320.

In an embodiment, the plurality of moving modules 320 and the plurality of attachment modules 330 may be disposed on the second plate 310-2. The plurality of moving modules 320 and the plurality of attachment modules 330 may be disposed on the second plate 310-2 along the first direction D1. The plurality of moving modules 320 and the plurality of attachment modules 330 may be alternately disposed.

In an embodiment, one of the plurality of moving modules 320 may be disposed to be spaced apart from the one side of the second plate 310-2 in the first direction D1, and the other moving module 320 may be disposed to be spaced apart from the other side of the second plate 310-2 in the first direction D1.

In an embodiment, when the moving module 320 disposed to be spaced apart from the one side of the second plate 310-2 in the first direction D1 is referred to as the first moving module 320 and the moving module 320 disposed to be spaced apart from the other side of the second plate 310-2 in the first direction D1 is referred to as the second moving module 320, the attachment module 330 may be disposed to be located between the first moving module 320 and the second moving module 320.

In an embodiment, the attachment module 330 may be disposed between the one side of the second plate 310-2 in the first direction D1 and the first moving module 320, and between the other side of the second plate 310-2 in the first direction D1 and the second moving module 320.

In an embodiment, the attachment module 330 disposed on the second plate 310-2 to be located between the first moving module 320 and the second moving module 320 may be disposed on the second plate 310-2 at a position that is located far away from the first moving module 320 by as much as a length of about 50% relative to the length between the first moving module 320 and the second moving module 320.

In an embodiment, the attachment module 330 disposed on the second plate 310-2 to be located between the one side of the second plate 310-2 in the first direction D1 and the first moving module 320 may be disposed on the second plate 310-2 at a position that is located far away from the first moving module 320 by as much as a length of about 50% relative to the length between the first moving module 320 and the moving module 320 disposed on the one side of the first plate 310-1 in the second direction D2. In other words, the attachment module 330 may be disposed on the second plate 310-2 at a middle point located between the first moving module 320 and the moving module 320 disposed on the one side of the first plate 310-1 in the second direction D2.

In addition, in an embodiment, the attachment module 330 disposed on the second plate 310-2 to be located between the other side of the second plate 310-2 in the first direction D1 and the second moving module 320 may be disposed on the second plate 310-2 at a position that is located far away from the second moving module 320 by as much as a length of about 50% between the second moving module 320 and the one side of the third plate 310-3 in the second direction D2. In other words, the attachment module 330 may be disposed on the second plate 310-2 at a middle point located between the second moving module 320 and the moving module 320 disposed on the one side of the third plate 310-3 in the second direction D2.

In an embodiment, the plurality of moving modules 320 and the plurality of attachment modules 330 may be disposed on the third plate 310-3. The plurality of moving modules 320 and the plurality of attachment modules 330 may be disposed on the third plate 310-3 along the second direction D2.

In an embodiment, one of the plurality of moving modules 320 may be disposed on the one side of the third plate 310-3 in the second direction D2, and the other moving module 320 may be disposed on the other side of the third plate 310-3 in the second direction D2.

In an embodiment, the plurality of attachment modules 330 may be disposed between the moving modules 320 disposed on the third plate 310-3. In other words, the plurality of attachment modules 330 may be disposed between the moving module 320 disposed on the one side of the third plate 310-3 in the second direction D2 and the moving module 320 disposed on the other side of the third plate 310-3 in the second direction D2. The plurality of attachment modules 330 may be disposed on the third plate 310-3 along the second direction D2.

In an embodiment, when the moving module 320 disposed on the one side of the third plate 310-3 in the second direction D2 is referred to as the first moving module 320 and the moving module 320 disposed on the other side of the third plate 310-3 is referred to as the second moving module 320, the plurality of attachment modules 330 may be disposed between the first moving module 320 and the second moving module 320 along the second direction D2.

In an embodiment, the plurality of attachment modules 330 may be disposed on the third plate 310-3 within the range from a position that is located far away from the first moving module 320 by as much as a length of about 20% relative to the length between the first moving module 320 and the second moving module 320 to a position that is located far away from the first moving module 320 by as much as a length of about 80% relative to the length between the first moving module 320 and the second moving module 320.

In addition, in an embodiment, one of the plurality of attachment modules 330 may be disposed on the third plate 310-3 at a position that is located far away from the first moving module 320 by as much as a length of about 50% relative to the length between the first moving module 320 and the second moving module 320. In other words, one of the plurality of attachment modules 330 may be disposed on the third plate 310-3 at a middle point between the first moving module 320 and the second moving module 320.

In an embodiment, the plurality of moving modules 320 and the plurality of attachment modules 330 may be disposed on the fourth plate 310-4. The plurality of moving modules 320 and the plurality of attachment modules 330 may be disposed on the second plate 310-2 along the first direction D1. The plurality of moving modules 320 and the plurality of attachment modules 330 may be alternately disposed.

In an embodiment, one of the plurality of moving modules 320 may be disposed to be spaced apart from the one side of the fourth plate 310-4 in the first direction D1, and the other moving module 320 may be disposed to be spaced apart from the other side of the fourth plate 310-4 in the first direction D1.

In an embodiment, when the moving module 320 disposed to be spaced apart from the one side of the fourth plate 310-4 in the first direction D1 is referred to as the first moving module 320 and the moving module 320 disposed to be spaced apart from the other side of the fourth plate 310-4 in the first direction D1 is referred to as the second moving module 320, the attachment module 330 may be disposed between the first moving module 320 and the second moving module 320.

In addition, in an embodiment, the attachment module 330 may be disposed between the one side of the fourth plate 310-4 in the first direction D1 and the first moving module 320, and may be disposed between the other side of the fourth plate 310-4 in the first direction D1 and the second moving module 320.

In an embodiment, the attachment module 330 disposed on the fourth plate 310-4 to be located between the first moving module 320 and the second moving module 320 may be disposed on the fourth plate 310-4 at a position that is located far away from the first moving module 320 by as much as a length of about 50% relative to the length between the first moving module 320 and the second moving module 320.

In an embodiment, the attachment module 330 disposed on the fourth plate 310-4 between the one side of the fourth plate 310-4 in the first direction D1 and the first moving module 320 may be disposed on the fourth plate 310-4 at a position that is located far away from the first moving module 320 by as much as a length of about 50% relative to the length between the first moving module 320 and the moving module 320 disposed on the other side of the first plate 310-1 in the second direction D2. In other words, the attachment module 330 may be disposed on the fourth plate 310-4 at a middle point between the first moving module 320 and the moving module 320 disposed on the other side of the first plate 310-1 in the second direction D2.

In addition, in an embodiment, the attachment module 330 disposed on the fourth plate 310-4 to be located between the other side of the fourth plate 310-4 in the first direction D1 and the second moving module 320 may be disposed on the fourth plate 310-4 at a position that is located far away from the second moving module 320 by as much as a length of about 50% relative to the length between the second moving module 320 and the moving module 320 disposed on the other side of the third plate 310-3 in the second direction D2. In other words, the attachment module 330 may be disposed on the fourth plate 310-4 at a middle point between the second moving module 320 and the moving module 320 disposed on the other side of the third plate 310-3 in the second direction D2.

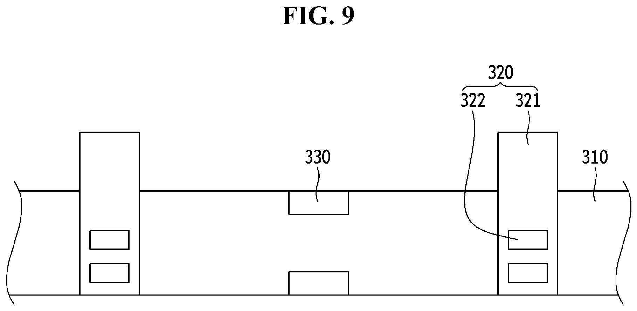

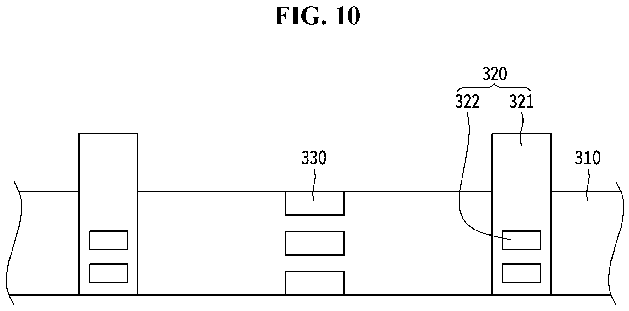

FIG. 9 is a view illustrating an example in which an attachment module 330 is disposed between moving modules 320 in FIG. 6, according to an embodiment. FIG. 10 is a view illustrating another example in which an attachment module 330 is disposed between moving modules 320 in FIG. 6, according to an embodiment.

In an embodiment and referring to FIGS. 9 and 10, the plurality of attachment modules 330 may be disposed to be spaced apart from each other in the other direction crossing the one direction in which the moving module 320 is disposed. For example, when an extension direction of the stage frame 310 is a length direction and a direction that is directed orthogonal to a length direction of the stage frame 310 on a plane is a width direction, the plurality of attachment modules 330 may be disposed to be spaced apart from each other in the width direction of the stage frame 310.

In an embodiment, one of the plurality of attachment modules 330 may be disposed on the one side (upper side of FIG. 9) of the stage frame 310 in the width direction, and the other attachment module 330 may be disposed on the other side (lower side of FIG. 9) of the stage frame 310 in the width direction. Also, another one of the plurality of attachment modules 330 may be disposed between the attachment module 330 disposed on the one side of the stage frame 310 in the width direction and the attachment module 330 disposed on the other side of the stage frame 310 in the width direction. In this way, when the plurality of attachment modules 330 are disposed in the width direction of the stage frame 310, the mask frame 210 may be more firmly attached to the stage frame 310 at the point where the attachment module 330 is disposed in the width direction.

Hereinafter, the action and effect of the mask stage 300 of the invention and the deposition apparatus 10 including the same will be described with reference to the drawings.

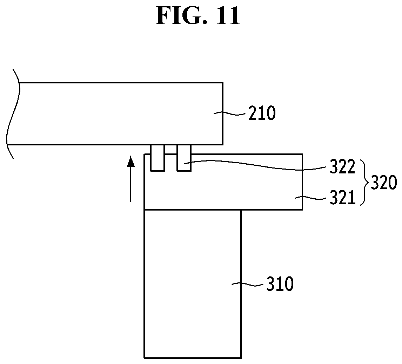

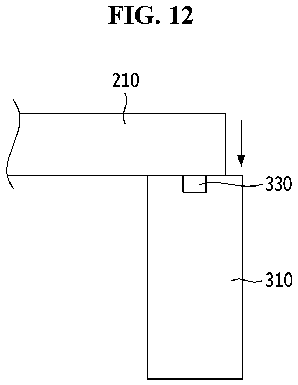

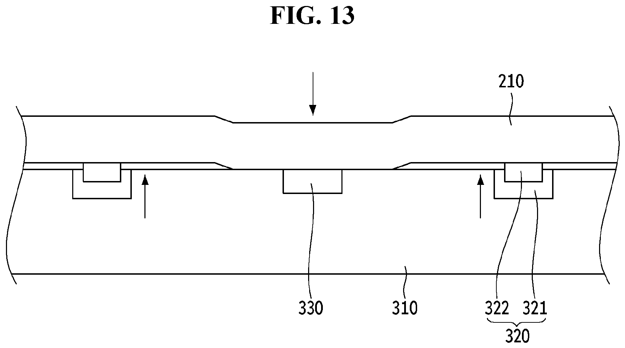

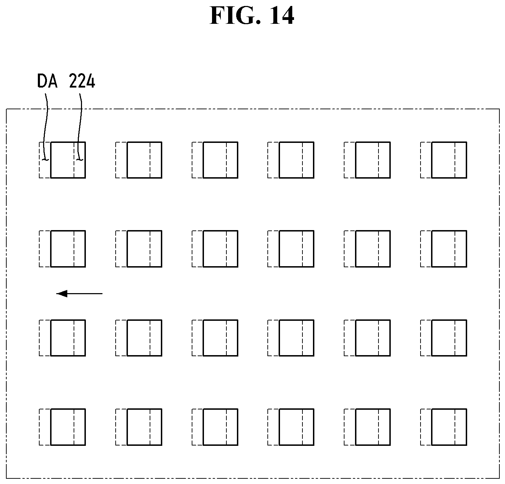

FIG. 11 is a view illustrating a state that a moving module 320 of a mask stage 300 moves a mask frame 210 in an upward direction of the mask stage 300, according to an embodiment. FIG. 12 is a view illustrating a state that an attachment module 330 of a mask stage 300 attaches a mask frame 210 to a stage frame 310, according to an embodiment. FIG. 13 is a view illustrating simultaneously states of FIGS. 11 and 12, according to an embodiment. FIG. 14 is a partially enlarged view illustrating a state that a mask assembly 200 of a deposition apparatus 10 is tightly adhered to a substrate SUB, according to an embodiment.

In an embodiment and referring to FIG. 11, the mask frame 210 seated on the upper portion of the stage frame 310 may be moved in an upward direction of the stage frame 310 by the moving module 320. As the moving member 322 disposed inside the main body 321 of the moving module 320 is ejected in an upward direction of the main body 321, the mask frame 210 may be moved in the upward direction of the stage frame 310.

In an embodiment and referring to FIG. 12, the mask frame 210 seated on the upper portion of the stage frame 310 may be attached to the stage frame 310 by the attachment module 330. When the mask frame 210 is attached to the stage frame 310, the power source may not be applied to the attachment module 330.

In an embodiment and referring to FIG. 13, a portion of the mask frame 210 may be moved to the upper portion of the stage frame 310 by the moving module 320, and another portion of the mask frame 210 may be attached to the stage frame 310 by the attachment module 330.

In an embodiment and referring to FIG. 14, when a portion of the mask frame 210 is moved to the upper portion of the stage frame 310 by the moving module 320, the deposition area DA of the substrate SUB and the pattern opening 224 of the mask assembly 200 may not be matched with each other. In this way, when the deposition area DA of the substrate SUB and the pattern opening 224 are not matched with each other due to the moving module 320, the attachment module 330 may attach a portion of the mask frame 210 to the stage frame 310, such that the pattern opening 224 may be moved in a direction of an arrow of FIG. 14, whereby the deposition area DA of the substrate SUB and the pattern opening 224 of the mask assembly 200 may be aligned.

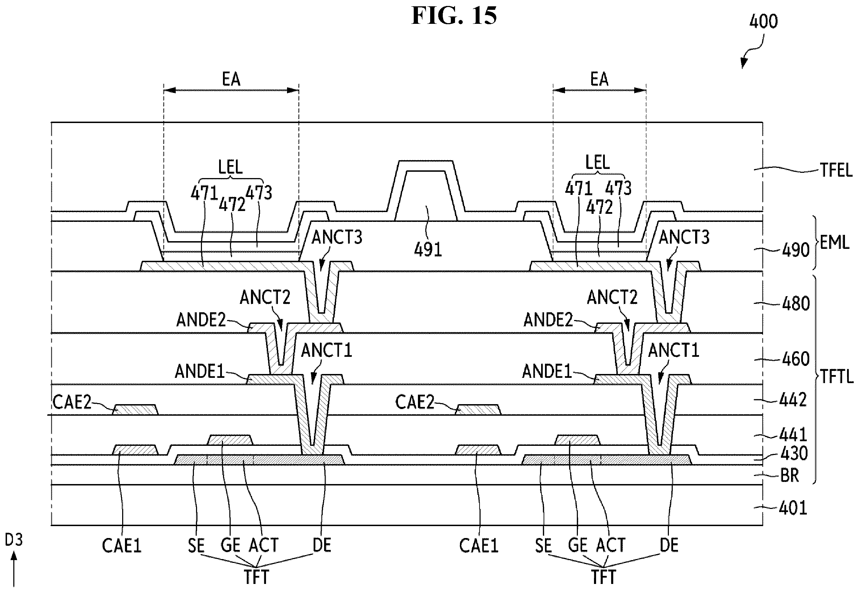

FIG. 15 is a cross-sectional view schematically illustrating a display device 400 manufactured using a deposition apparatus 10, according to an embodiment.

In an embodiment and referring to FIG. 15, a barrier layer BR may be disposed on a substrate 401, where the substrate 401 may be made of an insulating material such as a polymer resin. For example, the substrate 401 may be made of polyimide. The substrate 401 may be a flexible substrate capable of being subjected to bending, folding, rolling and the like.

In an embodiment, the barrier layer BR may be a layer for protecting transistors of a thin film transistor layer TFTL and a light emitting layer 472 of a light emitting element layer EML from moisture permeated through the substrate 401 that is vulnerable to moisture permeation. The barrier layer BR may be made of a plurality of inorganic layers alternately stacked. For example, the barrier layer BR may be formed of a multi-layer in which one or more inorganic layers of a silicon nitride layer, a silicon oxynitride layer, a silicon oxide layer, a titanium oxide layer and an aluminum oxide layer are alternately stacked.

In an embodiment, a thin film transistor TFT may be disposed on the barrier layer BR, where the thin film transistor TFT may include an active layer ACT and a gate electrode GE.

The active layer ACT of the thin film transistor TFT may be disposed on the barrier layer BR and may include polycrystalline silicon, monocrystalline silicon, low-temperature polycrystalline silicon, amorphous silicon or oxide semiconductor.

In an embodiment, the active layer ACT may include a channel area, a source area SE and a drain area DE. The channel area may be an area that overlaps the gate area GE in a third direction D3 that is a thickness direction of the substrate 401. The source area SE may be disposed at one side of the channel area, and the drain area DE may be disposed at the other side of the channel area. The source area SE and the drain area DE may be areas that do not overlap the gate electrode GE in the third direction D3. The source area SE and the drain area DE may be areas having conductivity by doping a silicon semiconductor or an oxide semiconductor with ions or impurities.

In an embodiment, a first gate insulating layer 430 may be disposed on the active layer ACT of the thin film transistor TFT. The first gate insulating layer 430 may be formed of an inorganic layer, for example, a silicon nitride layer, a silicon oxynitride layer, a silicon oxide layer, a titanium oxide layer or an aluminum oxide layer.

In an embodiment, the gate electrode GE of the thin film transistor TFT and a first capacitor electrode CAE1 may be disposed on the first gate insulating layer 430. The gate electrode GE may overlap the active layer ACT in the third direction D3. Although FIG. 15 shows that the gate electrode GE and the first capacitor electrode CAE1 are disposed to be spaced apart from each other, in another embodiment the gate electrode GE and the first capacitor electrode CAE1 may be connected to each other. The gate electrode GE and the first capacitor electrode CAE1 may be formed of a single layer or multi-layer made of molybdenum (Mo), aluminum (Al), chromium (Cr), gold (Au), titanium (Ti), nickel (Ni), neodymium (Nd) and copper (Cu) or their alloy.

In an embodiment, a first interlayer insulating layer 441 may be disposed on the gate electrode GE of the thin film transistor TFT and the first capacitor electrode CAE1. The first interlayer insulating layer 441 may be formed of an inorganic layer, for example, a silicon nitride layer, a silicon oxynitride layer, a silicon oxide layer, a titanium oxide layer or an aluminum oxide layer. The first interlayer insulating layer 441 may be formed of a plurality of inorganic layers.

In an embodiment, a second capacitor electrode CAE2 may be disposed on the first interlayer insulating layer 441 and may overlap the first capacitor electrode CAE1 of the thin film transistor TFT in the third direction D3. When the first capacitor electrode CAE1 is connected to the gate electrode GE, the second capacitor electrode CAE2 may overlap the gate electrode GE in the third direction D3. Since the first interlayer insulating layer 441 has a predetermined dielectric constant, a capacitor may be formed by the first capacitor electrode CAE1, the second capacitor electrode CAE2, and the first interlayer insulating layer 441 disposed therebetween. The second capacitor electrode CAE2 may be formed of a single layer or multi-layer made of molybdenum (Mo), aluminum (Al), chromium (Cr), gold (Au), titanium (Ti), nickel (Ni), neodymium (Nd) and copper (Cu) or their alloy.

In an embodiment, a second interlayer insulating layer 442 may be disposed on the second capacitor electrode CAE2 and may be formed of an inorganic layer, for example, a silicon nitride layer, a silicon oxynitride layer, a silicon oxide layer, a titanium oxide layer or an aluminum oxide layer. The second interlayer insulating layer 442 may be formed of a plurality of inorganic layers.

In an embodiment, a first anode connection electrode ANDE1 may be disposed on the second interlayer insulating layer 442 and may be connected to the drain area DE of the thin film transistor TFT through a first connection contact hole ANCT1 passing through the first gate insulating layer 430, the first interlayer insulating layer 441 and the second interlayer insulating layer 442. The first anode connection electrode ANDE1 may be formed of a single layer or multi-layer made of any one of molybdenum (Mo), aluminum (Al), chromium (Cr), gold (Au), titanium (Ti), nickel (Ni), neodymium (Nd) and copper (Cu) or their alloy.

In an embodiment, a first planarization layer 460 for planarizing a step difference due to the thin film transistor TFT may be disposed on the first anode connection electrode ANDE1. The first planarization layer 460 may be formed of an organic layer such as an acrylic resin, an epoxy resin, a phenolic resin, a polyamide resin and a polyimide resin.

In an embodiment, a second anode connection electrode ANDE2 may be disposed on the first planarization layer 460 and may be connected to the first anode connection electrode ANDE1 through a second connection contact hole ANCT2 passing through the first planarization layer 460. The second anode connection electrode ANDE2 may be formed of a single layer or multi-layer made of any one of molybdenum (Mo), aluminum (Al), chromium (Cr), gold (Au), titanium (Ti), nickel (Ni), neodymium (Nd) and copper (Cu) or their alloy.

In an embodiment, a second planarization layer 480 may be disposed on the second anode connection electrode ANDE2 and may be formed of an organic layer such as an acrylic resin, an epoxy resin, a phenolic resin, a polyamide resin, a polyimide resin and a polyimide resin.

In an embodiment, light emitting elements LEL and a bank 490 may be disposed on the second planarization layer 480, where each of the light emitting elements LEL may include a pixel electrode 471, a light emitting layer 472 and a common electrode 473.

The pixel electrode 471 may be disposed on the second planarization layer 480 and may be connected to the second anode connection electrode ANDE2 through a third connection contact hole ANCT3 passing through the second planarization layer 480.

In a top emission structure that emits light in a direction of the common electrode 473 with respect to the light emitting layer 472, the pixel electrode 471 may be formed of a metal material having high reflectance, such as a stacked structure (Ti/Al/Ti) of aluminum and titanium, a stacked structure (ITO/Al/ITO) of aluminum and indium tin oxide (ITO), an APC alloy and a stacked structure (ITO/APC/ITO) of APC alloy and ITO. The APC alloy may be an alloy of silver (Ag), palladium (Pd) and copper (Cu).

In an embodiment, the bank 490 may be formed to partition the pixel electrode 471 on the second planarization layer 480, thereby defining a plurality of light emission areas EA. The bank 490 may be disposed to cover an edge of the pixel electrode 471 and may be formed of an organic layer such as an acrylic resin, an epoxy resin, a phenolic resin, a polyamide resin and a polyimide resin.

In an embodiment, each of the plurality of light emission areas EA represents an area in which the pixel electrode 471, the light emitting layer 472 and the common electrode 473 are sequentially stacked to recombine holes from the pixel electrode 471 with electrons from the common electrode 473 in the light emitting layer 472, thereby emitting light.

In an embodiment, the light emitting layer 472 may be disposed on the pixel electrode 471 and the bank 490, and may include an organic material to emit light of a predetermined color. For example, the light emitting layer 472 includes a hole transporting layer, an organic material layer and an electron transporting layer.

In an embodiment, the common electrode 473 may be disposed on the light emitting layer 472 and may be disposed to cover the light emitting layer 472. The common electrode 473 may be a common layer commonly formed in the plurality of light emission areas EA. Additionally, a capping layer may be formed on the common electrode 473.

In an embodiment, in the top emission structure, the common electrode 473 may be formed of a transparent metal material TCO such as ITO and IZO, which may transmit light, or a semi-transmissive conductive material such as magnesium (Mg), silver (Ag) or an alloy of magnesium (Mg) and silver (Ag). When the common electrode 473 is formed of a semi-transmissive metal material, emission efficiency may be increased by a micro cavity.

In an embodiment, a spacer 491 may be disposed on the bank 490, where the spacer 491 may serve to support the mask assembly 200 during a manufacturing process of manufacturing the light emitting layer 472. For example, the spacer 491 may support the divided mask 220 of the mask assembly 200. The spacer 491 may prevent the divided mask 220 from sagging and may be formed of an organic layer such as an acrylic resin, an epoxy resin, a phenolic resin and a polyimide resin.

In an embodiment, an encapsulation layer TFEL may be disposed on the common electrode 473 and may include at least one inorganic layer to prevent oxygen or moisture from being permeated into the light emitting layer 472 of the light emitting element layer EML. Also, the encapsulation layer TFEL may include at least one organic layer to protect the light emitting element layer EML from particles such as dust. The encapsulation layer TFEL may include an inorganic layer and an organic layer in accordance with various embodiments.

It should be understood that the aspects and features of embodiments of the invention are not restricted to those set forth herein. The above and other aspects of the invention will become more apparent to one of ordinary skill in the art to which the invention pertains. Thus, it will be understood by one of ordinary skill in the art to which the invention belongs that the invention may be implemented in other specific embodiments than those described herein without changing the essential features of the invention. Therefore, it is to be understood that the example embodiments described above are illustrative rather than being restrictive in all aspects. The disclosed embodiments of the invention are used in a generic and descriptive sense only and not for purposes of limitation. Each component specifically shown in the embodiments of the invention can be implemented by modification, and such modifications and differences related to invention should be construed as being included in the scope of the invention. Moreover, the embodiments or parts of the embodiments may be combined in whole or in part without departing from the scope of the invention.

## Claims

1. A mask stage comprising:
a stage frame supporting a mask frame;
a plurality of moving modules disposed on the stage frame to overlap the mask frame; and
a plurality of attachment modules disposed on the stage frame to overlap the mask frame,
wherein the plurality of moving modules and the plurality of attachment modules are spaced apart from each other, and
wherein at least one attachment module is disposed between the plurality of moving modules.

2. The mask stage of claim 1, wherein the plurality of moving modules are disposed to be spaced apart from each other in one direction, and
the plurality of attachment modules are disposed to be spaced apart from each other in the one direction to be disposed between the plurality of moving modules.

3. The mask stage of claim 2, wherein some of the plurality of attachment modules are disposed to be spaced apart from each other in another direction crossing the one direction.

4. The mask stage of claim 1, 2 or 3, wherein the plurality of moving modules include a first moving module and a second moving module, and
the plurality of attachment modules are disposed within a range from a position far away from the first moving module by as much as a length of about 20% relative to a length between the first moving module and the second moving module to a position far away from the first moving module by as much as a length of about 80% relative thereto.

5. The mask stage of claim 4, wherein one of the plurality of attachment modules is disposed at a position far away from the first moving module by as much as a length of about 50% relative to a length between the first moving module and the second moving module.

6. The mask stage of any preceding claim, wherein the stage frame includes a first plate, a second plate, a third plate and a fourth plate, and
wherein the first plate and the third plate are extended in a second direction, and are disposed to be parallel with each other, and
wherein the second plate and the fourth plate are extended in a first direction crossing the second direction, and are disposed to be parallel with each other,

7. The mask stage of claim 6, wherein the plurality of moving modules are disposed on the first plate and the third plate along the second direction, and
the plurality of attachment modules are disposed to be between the plurality of moving modules disposed on the first plate and the third plate, and optionally
wherein the plurality of moving modules are disposed on one side and the other side of the first plate and the third plate in the second direction, and/or
wherein the plurality of attachment modules are disposed on the first plate and the third plate along the second direction.

8. The mask stage of claim 6 or 7, wherein the plurality of moving modules are disposed on the second plate and the fourth plate along the first direction,
wherein the plurality of attachment modules are disposed on the second plate and the fourth plate along the first direction, and
wherein the plurality of moving modules and the plurality of attachment modules are alternately disposed.

9. The mask stage of claim 8, wherein the plurality of moving modules are disposed to be spaced apart from one side and the other side of the second plate and the fourth plate in the first direction, and optionally
wherein a portion of the plurality of attachment modules is disposed between one side of the second plate and the fourth plate in the first direction and wherein the moving module is spaced apart from one side of the second plate and the fourth plate in the first direction, and is disposed between the other side of the second plate and the fourth plate in the first direction and wherein the moving module is spaced apart from the other side of the second plate and the fourth plate in the first direction.

10. The mask stage of any preceding claim, wherein the moving module moves the mask frame in an up and down direction relative to the stage frame, and
wherein the attachment module attaches the mask frame to the stage frame.

11. The mask stage of claim 10, wherein the moving module includes:
a main body embedded in the stage frame; and
a moving member ejected toward an upper portion of the stage frame from the main body.

12. The mask stage of claim 10 or 11, wherein the attachment module is embedded in the stage frame, and is partially exposed to the upper portion of the stage frame, and optionally
wherein the attachment module is provided as a zero-electromagnet in which a magnetic force is removed when a power source is applied and the magnetic force is generated when the power source is removed.

13. A deposition apparatus comprising:
a chamber;
a substrate holder disposed inside the chamber and supporting a substrate;
a mask assembly disposed below the substrate;
a mask stage supporting the mask assembly; and
a deposition source emitting a deposition material to the mask assembly,
wherein the mask stage includes:
a plurality of moving modules that overlap the mask assembly; and
a plurality of attachment modules that overlap the mask assembly, wherein
at least one attachment module is disposed between the plurality of moving modules.

14. The deposition apparatus of claim 13, wherein the plurality of moving modules are disposed to be spaced apart from each other in one direction, and
the plurality of attachment modules are disposed to be spaced apart from each other in the one direction to be disposed between the plurality of moving modules, and optionally
wherein some of the plurality of attachment modules are disposed to be spaced apart from each other in another direction crossing the one direction.

15. The deposition apparatus of claim 13 or 14, wherein the plurality of moving modules include a first moving module and a second moving module, and
wherein the plurality of attachment modules are disposed within a range from a position far away from the first moving module by as much as a length of about 20% relative to a length between the first moving module and the second moving module to a position far away from the first moving module by as much as a length of about 80% relative thereto, and optionally
wherein one of the plurality of attachment modules is disposed at a position far away from the first moving module by as much as a length of about 50% relative to the length between the first moving module and the second moving module.
